# EUROPEAN PATENT SPECIFICATION

(11) **EP 0 477 063 B1**
(45) Date of publication and mention of the grant of the patent: **04.12.1996**
(21) Application number: 91402384.1
(22) Date of filing: 05.09.1991
(51) Int. Cl.: H01L 39/22, H01L 39/24

(54) **Superconducting device having a reduced thickness of oxide superconducting layer and method for manufacturing the same**
Supraleitendes Bauelement mit verringerter Dicke der supraleitenden Oxydschicht und dessen Herstellungsverfahren
Dispositif à supraconducteur ayant une couche d'oxyde supraconductrice à épaisseur réduite et procédé pour sa fabrication

(30) Priority: 06.09.1990 JP 236534/90; 27.09.1990 JP 257857/90
(43) Date of publication of application: 25.03.1992
(73) Proprietor: Sumitomo Electric Industries, Ltd., Osaka 541 (JP)
(72) Inventor: Nakamura, Takao, F-75116 Paris (FR); Inada, Hiroshi, F-75116 Paris (FR); Iiyama, Michitomo, F-75116 Paris (FR)
(74) Representative: Ballot, Paul Denis Jacques

(56) References cited:
- EP-A- 0 280 308
- EP-A- 0 354 804
- PATENT ABSTRACTS OF JAPAN, vol. 13, no. 110 (E- 728)(3458), 16 March 1989 & JP-A-63 283 085

## Description

### Background of the Invention

### Field of the invention

The present invention relates to a superconducting device and a method for manufacturing the same, and more specifically to a superconducting device including an oxide superconducting layer having a planar upper surface and a partially reduced thickness, and a method for manufacturing the same.

### Description of related art

Typical three-terminal devices which utilize a superconductor include a so called superconducting-base transistor and a so called super-FET (field effect transistor). The superconducting-base transistor includes an emitter of a superconductor or a normal conductor, a tunnel barrier of an insulator, a base of a superconductor, a semiconductor isolator and a collector of a normal conductor, stacked in the named order. This superconductingrbase transistor operates at a high speed and with a low power consumption, by utilizing high speed electrons passing through the tunnel barrier.

The super-FET includes a semiconductor layer, and a superconductor source electrode and a superconductor drain electrode which are formed closely to each other on the semiconductor layer. A portion of the semiconductor layer between the superconductor source electrode and the superconductor drain electrode has a greatly recessed or undercut rear surface so as to have a reduced thickness. In addition, a gate electrode is formed through a gate insulator layer on the recessed or undercut rear surface of the portion of the semiconductor layer between the superconductor source electrode and the superconductor drain electrode.

A superconducting current flowing through the semiconductor layer portion between the superconductor source electrode and the superconductor drain electrode due to a superconducting proximity effect is controlled by an applied gate voltage. This super-FET also operates at a high speed with a low power consumption.

In addition, in the prior art, there has been proposed a three-terminal superconducting device having a channel of a superconductor formed between a source electrode and a drain electrode, so that a current flowing through the superconducting channel is controlled by a voltage applied to a gate formed above the superconducting channel.

Both of the above mentioned superconducting-base transistor and the super-FET have a portion in which a semiconductor layer and a superconducting layer are stacked to each other. However, it is difficult to form a stacked structure of the semiconductor layer and the superconducting layer formed of an oxide superconductor which has been recently advanced in study. In addition, even if it is possible to form a stacked structure of the semiconductor layer and the oxide superconducting layer, it is difficult to control a boundary between the semiconductor layer and the oxide superconducting layer. Therefore, a satisfactory operation could not been obtained in these superconducting devices.

In addition, since the super-FET utilizes the superconducting proximity effect, the superconductor source electrode and the superconductor drain electrode have to be located close to each other at a distance which is a few times the coherence length of the superconductor materials of the superconductor source electrode and the superconductor drain electrode. In particular, since an oxide superconductor has a short coherence length, if the superconductor source electrode and the superconductor drain electrode are formed of the oxide superconductor material, a distance between the superconductor source electrode and the superconductor drain electrode has to be on the order of a few ten nanometers. It is very difficult to conduct a fine processing such as a fine pattern etching so as to ensure the very short separation distance. Because of this, in the prior art, it has been impossible to manufacture the super-FET composed of the oxide superconductor material.

Furthermore, it has been confirmed that the conventional three-terminal superconducting device having the superconducting channel shows a modulation operation. However, the conventional three-terminal superconducting device having the superconducting channel could not realize a complete ON/OFF operation, because a carrier density is too high. In this connection, since an oxide superconductor material has a low carrier density, it is expected to form a three-terminal superconducting device which has a superconducting channel and which can realize the complete ON/OFF operation, by forming the superconducting channel of the oxide superconductor material. In this connection, however, a thickness of the superconducting channel has to be made on the order of five nanometers.

On the other hand, typical two-terminal devices which utilize a superconductor include a so called Josephson device, which comprises a pair of superconductors coupled to each through a tunnel barrier. The Josephson device can realize a high speed switching.

The Josephson device formed of an oxide superconductor material thin film can be realized in the form of a planer type, which is divided into a Dayem bridge (DMB) type and a variable thickness bridge (VTB) type.

The Dayem bridge type Josephson device has been formed of a constant thickness oxide superconductor thin film which is formed on a substrate and which is patterned in a plan view, so that a superconductor thin film region having a greatly narrow width is formed between a pair of superconductor thin film regions having a sufficient width. In other words, the pair of superconductor thin film regions having a sufficient width are coupled to each other by the superconductor thin film region having the greatly narrow width. Namely, a weak link of the Josephson junction in the superconductor thin film is formed at the greatly narrow width region.

On the other hand, the variable thickness bridge type Josephson device has been formed of an oxide superconductor thin film of a sufficient thickness which is formed on a substrate and which is partially etched or thinned in a thickness direction, so that a thinned oxide superconductor thin film portion is formed between a pair of superconductor thin film portion having the sufficient thickness. In other words, the pair of superconductor thin film portions having the sufficient thickness are coupled to each other by the thinned oxide superconductor thin film portion. Accordingly, a weak link of the Josephson junction is formed at the reduced thickness portion of the oxide superconductor thin film.

As would be understood from the above, a characteristics of the planar type Josephson device has a close relation to the width of the superconductor thin film region having the greatly narrow width in the Dayem bridge type Josephson device, and to the thickness of the thinned oxide superconductor thin film portion in the variable thickness bridge type Josephson device, both of which form the weak link of the Josephson junction. Therefore, in order to obtain a desired characteristics with a good repeatability, a high precision on a sub-micron level of the processing such as the etching is required.

The Dayem bridge type Josephson device can be said to be more preferable than the variable thickness bridge type Josephson device, since the Dayem bridge type Josephson device has a relatively planer surface, which is preferred in a integrated circuit. However, in order to form the weak link in the Dayem bridge type Josephson device, it is required to pattern an oxide superconductor thin film having the thickness on the order of 0.5µm to 1.0µm into a width of not greater than 0.2µm. However, it is very difficult to conduct this fine patterning with good repeatability.

On the other hand, in the variable thickness bridge type Josephson device, the very fine pattering is not required in order to form the weak link. However, it is very difficult to uniformly control the remaining thickness of the thinned portion forming the weak link. In addition, the variable thickness bridge type Josephson device cannot have a satisfactorily planer surface. This is not preferable to the integrated circuit application.

Furthermore, European Patent Application n° 0 280 308 discloses a superconducting device comprising a substrate 8, having a projection on it, and an oxide superconducting thin film formed on said substrate, with the c-axis perpendicular to the substrate's surface, and covering said projection.

### Summary of the Invention

Accordingly, it is an object of the present invention to provide a superconducting device and a method for manufacturing the same, which overcomes the above mentioned defects of the conventional ones.

Another object of the present invention is to provide a FET type superconducting device including a channel composed of an oxide superconducting layer having a planar upper surface and a partially reduced thickness, and a method for manufacturing the same with a good repeatability by using existing established processing techniques.

Still another object of the present invention is to provide a Josephson junction superconducting device including a weak link composed of an oxide superconducting layer having a planar upper surface and a partially reduced thickness, and a method for manufacturing the same with a good repeatability by using existing established processing techniques.

The above and other objects of the present invention are achieved in accordance with the present invention by a superconducting device according to claim 1.

A gate electrode can be formed through an insulation barrier on the thinned portion of the oxide superconductor thin film positioned on the projection of the substrate, so that the electric current flowing between the first and second electrodes through the thinned portion of the oxide superconductor thin film is controlled by a voltage applied to the gate electrode. In this case, the superconducting device constitutes a super-FET, and one of the first and second electrodes forms a source electrode and the other forms a drain electrode. In this connection, the first and second electrodes and the gate electrodes can be formed of a superconducting material, but can also be formed of a material, such as a normal conducting material, other than the superconducting material.

As mentioned hereinbefore, in the conventional super-FET, a superconducting current flows through the semiconductor channel due to the superconducting proximity effect. However, in the super-FET in accordance with the present invention, a main current flows through the superconductor. Therefore, the limitation in the fine processing techniques required for manufacturing the super-FET can be relaxed.

The above mentioned superconducting device in accordance with the present invention can be formed by the manufacturing method according to claim 8.

As mentioned hereinbefore, in the conventional superconducting device, after the superconductor thin film having a uniform thickness and flat upper and lower surfaces was formed, the superconductor thin film is partially abraded or removed in a thickness direction so as to form a thinned superconductor thin film portion which constitutes a superconducting channel in the super-FET and a weak link in the Josephson device. However, since the required thickness of the thinned superconductor thin film portion is very small, an extremely high degree of precision in a fine processing (for example, etching) has been required in order to obtain a desired characteristics of the superconducting device.

On the other hand, in the above mentioned method in accordance with the present invention, since the superconductor thin film is formed to cover the projection, and then, a whole surface of the superconductor thin film is removed back and planarized. Therefore, it is no longer necessary to conduct a high degree of fine processing such as a fine etching.

In addition, since the upper surface of the superconductor thin film has a planarized upper surface, the superconducting device is very convenient in order to be assembled in an integrated circuit.

In the super-FET, the superconducting channel is turned on and off by a voltage applied to the gate electrode. Therefore, a thickness of the superconducting channel has to be on the order of five nanometers in the direction of an electric field created by the voltage applied to the gate electrode. This extremely thin superconducting channel can be easily realized or formed in accordance with the method of the present invention, since the superconducting channel is formed of the oxide superconductor thin film portion which is positioned on the projection of the substrate and which had been extremely thinned by removing and planarizing the whole upper surface of the oxide superconductor thin film formed on the principal surface of the substrate having the projection.

If the oxide superconductor thin film is simply deposited or grown on the principal surface of the substrate having the projection, the thickness of the oxide superconductor thin film on the projection is the same as that of the oxide superconductor thin film on the principal surface without the projection. As mentioned above, in the present invention, the whole of the oxide superconductor thin film thus formed is planarized so as to thin the oxide superconductor thin film portion on the projection. Since the whole of the oxide superconductor thin film can be easily planarized and removed with a high degree of controllability, it is possible to relatively easily form the oxide superconductor thin film having a desired thickness on the projection of the principal surface of the substrate.

The superconducting device in accordance with the present invention, the substrate, on which the oxide superconductor thin film is deposited, can be formed of an insulating substrate, preferably an oxide single crystalline substrate such as MgO, SrTiO₃, CdNdAlO₄, etc. These substrate materials are very effective in forming or growing a crystalline film having a high orientation property. However, the substrate can be formed on a semiconductor substrate if an appropriate buffer layer is deposited thereon.

Furthermore, the oxide superconductor thin film can be formed of different oxide superconductor materials, for example, a Y-Ba-Cu-O type compound oxide superconductor material, a Bi-Sr-Ca-Cu-O type compound oxide superconductor material, and a Tl-Ba-Ca-Cu-O type compound oxide superconductor material.

The above and other objects, features and advantages of the present invention will be apparent from the following description of preferred embodiments of the invention with reference to the accompanying drawings.

### Brief Description of the Drawings

Figure 1 is a diagrammatic sectional view of one embodiment of the superconducting device in accordance with the present invention;
Figures 2A to 2H are diagrammatic sectional views for illustrating the process for manufacturing the superconducting device shown in Figure 1;
Figure 3 is a diagrammatic perspective view of another embodiment of the superconducting device in accordance with the present invention; and
Figures 4A to 4H are diagrammatic sectional views for illustrating the process for manufacturing the superconducting device shown in Figure 3.

### Description of the Preferred embodiments

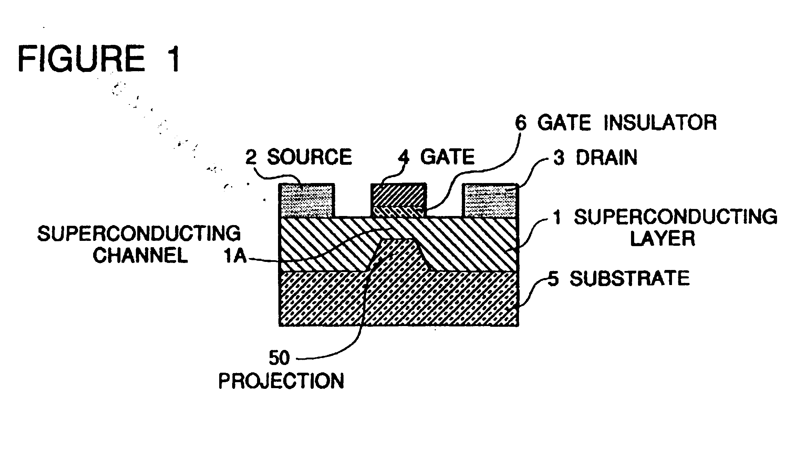

Referring to Figure 1, there is shown a diagrammatic sectional view of one embodiment of the superconducting device in accordance with the present invention. The shown superconducting device is a super-FET.

The super-FET includes an oxide superconducting layer 1 formed on a principal surface of a substrate 5 having a projection 50. The oxide superconducting layer 1 has a planarized upper surface, and therefore, a portion of the oxide superconducting layer 1 on the projection is thinner than the other portion of the oxide superconducting layer 1. This thin portion of the oxide superconducting layer 1 on the projection forms a superconducting channel 1A. On the superconducting channel 1A, a gate electrode 4 is formed through a gate insulator 6. In addition, a source electrode 2 and a drain electrode 3 are formed on the oxide superconducting layer 1 at both sides of the superconducting channel 1A.

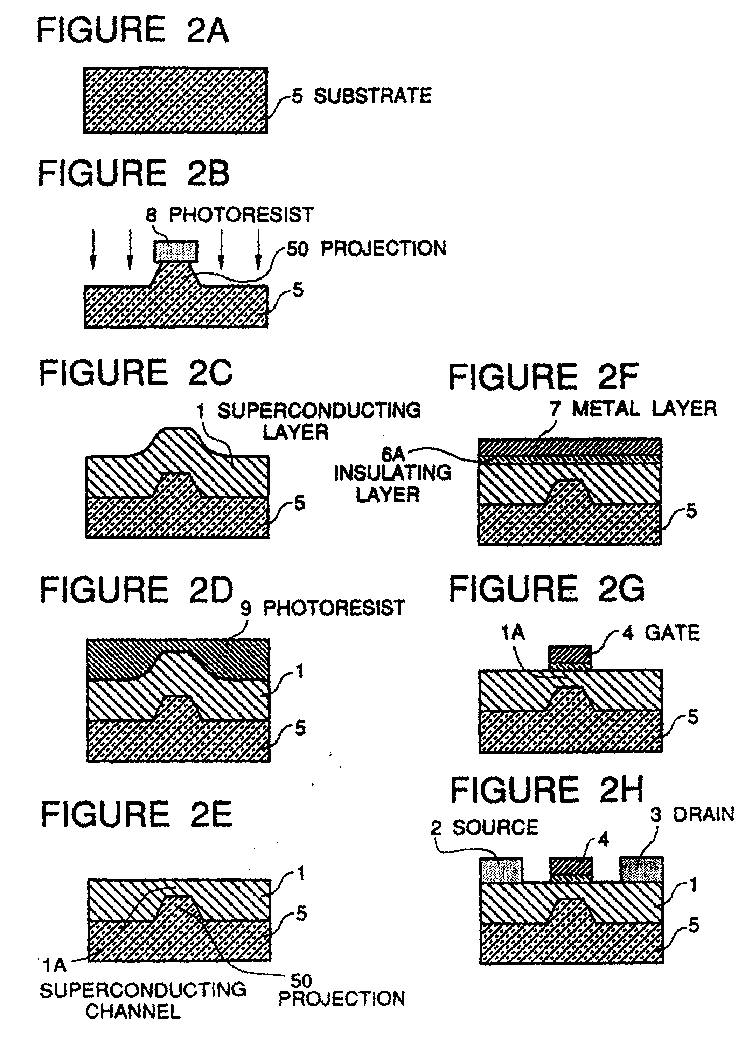

Now, the process for manufacturing the above mentioned superconducting device will be described with reference to Figures 2A to 2H.

First, the substrate 5 is prepared as shown in Figure 2A. This substrate 5 is formed of for example, an insulating substrate such as a MgO (100) substrate, a SrTiO₃ (100) substrate or others, or a semiconductor substrate such as a silicon having a principal surface coated with an insulating film. However, if the semiconductor substrate is used, after the projection is formed on the principal surface, the insulating film is formed on the principal surface.

As shown in Figure 2B, a photoresist mask 8 is formed on a portion of the principal surface of the substrate 5 corresponding to a projection forming position, and the principal surface of the substrate 5 is selectively etched or recessed by a dry etching process such as an Ar ion etching, so that a projection 50 is formed on the principal surface of the substrate 5. Thereafter, the photoresist mask 8 is removed.

In the case that a semiconductor substrate is used, a crystalline direction is important, and therefore, the process is modified. For example, if a silicon substrate is used, a photoresist mask 8 is formed so as to ensure that a gate length direction (a channel current direction) is in parallel to a Si(100) plane and perpendicular to a Si(110) plane. The silicon substrate partially masked with the photoresist 8 is etched with an etching liquid such as KOH or APW, so that a projection 50 is formed. after the photoresist mask 8 is removed, the principal surface having the projection 50 is continuously coated with MgAlO₄ by a CVD (chemical vapor deposition) and with BaTiO₃ by a sputtering process.

Then, as shown in Figure 2C, an oxide superconductor thin film 1 is deposited on the principal surface of the substrate 5, by for example an off-axis sputtering, a reactive evaporation, and MBE (molecular beam epitaxy), a CVD, etc. The oxide superconductor material is preferably formed of, for example, a Y-Ba-Cu-O type compound oxide superconductor material, a Bi-Sr-Ca-Cu-O type compound oxide superconductor material, and a Tl-Ba-Ca-Cu-O typa compound oxide superconductor material. In addition, a *c*-axis oriented thin film is preferably deposited, since the *c*-axis oriented thin film has a large critical current density in a direction in parallel to the substrate surface.

The oxide superconductor thin film 1 as deposited has a uniform thickness anywhere. Therefore, it is necessary to planarize an upper surface of the deposited oxide superconductor thin film, and to thin an oxide superconductor thin film portion on the projection 50. For this purpose, as shown in Figure 5D, a photoresist layer 9 is deposited on the oxide superconductor thin film 1 in such a manner that the deposited photoresist layer 9 has a plat upper surface.

Thereafter, as shown in Figure 2E, an Ar ion etching is performed until the upper surface of the oxide superconductor thin film 1 is planarized and a thickness of the oxide superconductor thin film 1 on the projection 50 becomes five nanometers so as to constitute the superconducting channel 1A.

Next, a gate electrode is formed on the superconducting channel 1A. This gate electrode is preferably composed of an insulating layer formed on the superconducting channel 1A and a metal layer stacked on the insulating layer. For this purpose, as shown in Figure 2F,an insulating layer 6A and a metal layer 7 are sequentially formed on the oxide superconductor thin film 1. The insulating layer 6A is formed of an insulating material such as MgO, which does not form a large density of energy levels between the superconductor thin film 1 and the insulating layer 6A. On the other hand, the metal layer 7 is preferably formed of a refractory metal such as Ti, W, etc., or Au, or a silicide thereof.

The stacked layer of the insulating layer 6A and the metal layer 7 is selectively removed by etching, so that the gate electrode 4 is formed on only the superconducting channel 1A, as shown in Figure 2G.

Finally, as shown in Figure 2H, a source electrode 2 and a drain electrode 3 of Au are formed on the oxide superconductor thin film 1 at both sides of the gate electrode 4, respectively. With this, the super-FET in accordande with the present invention is completed.

As explained above, if the super-FET in accordance with the present invention is manufactured in accordance with the method of the present invention, the limitation in the fine processing technique required for manufacturing the super-FET is relaxed. In addition, since the upper surface of the superconductor thin film is planarized, it become easy to form conductor wirings in a later process. Accordingly, it is easy to manufacture the super-FET with good repeatability, and the manufactured super-FET has a stable performance.

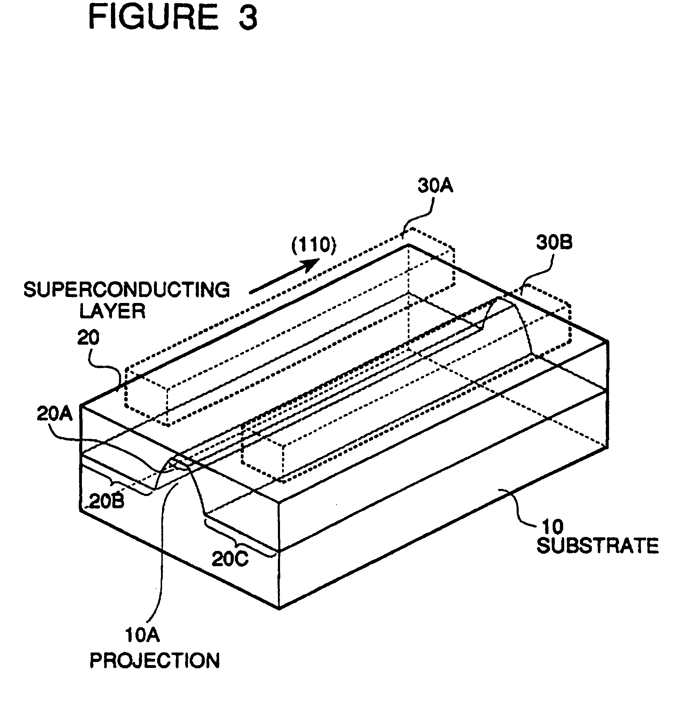

Referring to Figure 3, there is shown a diagrammatic perspective view of another embodiment of the superconducting device in accordance with the present invention. This second embodiment is a Josephson device.

The Josephson device includes a substrate 10 and an oxide superconductor thin film 20 formed on the substrate 10. The substrate 10 includes a projection 10A formed on a principal surface thereof. On the other hand, the oxide superconductor thin film 20 formed on the substrate 10 has a planarized upper surface, and therefore, has a reduced thickness on the projection 10 A.

The reduced thickness portion of the oxide superconductor thin film 20 on the projection 10A forms a weak link 20A of the Josephson device. Oxide superconductor thin film portions at both sides of the weak link 20A form a pair of superconductor electrode regions 20B and 20C, respectively. Thus, the weak link 20A and the superconductor electrode regions 20B and 20C are formed of a single oxide superconductor thin film integrally deposited on the substrate. In addition, a pair of normal conductor electrodes 30A and 30B can be formed on the superconductor electrode regions 20B and 20C, respectively.

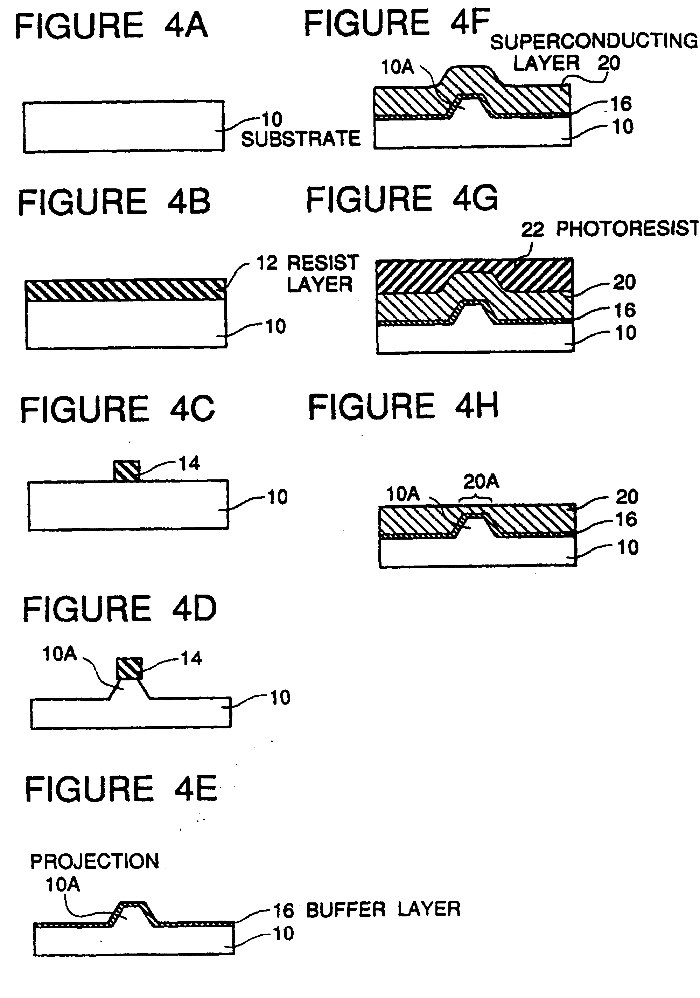

Now, the process for manufacturing the above mentioned superconducting device will be described with reference to Figures 4A to 4H. In the embodiment which will be described below, a Y-Ba-Cu-O type compound oxide superconductor material is used for forming the oxide superconductor thin film.

First, the substrate 10 having a flat upper or principal surface is prepared as shown in Figure 4A. This substrate 10 is formed of a silicon substrate wafer. As mentioned hereinbefore, however, the substrate can be formed of an insulating substrate such as a MgO (100) substrate, a CdNdAlO₃ (001) substrate or others. If these substrates are used, a *c*-axis orientated oxide superconductor thin film having a large critical current density in a direction in parallel to the substrate surface can be formed on the substrate.

As shown in Figure 4B, a photoresist layer 12 is formed to cover the whole of the principal surface of the substrate 10. As shown in Figure 4C, the photoresist layer 12 is patterned so as to form or leave on the principal surface of the substrate 10 a photoresist mask 14 which is slightly larger in a plan view size than that of a current direction length of the weak link region 20A of a final or completed Josephson device. In this case, the photoresist mask 14 is formed so as to ensure that a lengthwise direction of the photoresist mask 14 (a direction perpendicular to the paper surface of Figure 4C) is in parallel to a (110) plane of the silicon substrate 10.

Therefore, as shown in Figure 4D, the principal surface of the substrate 10 partially masked with the photoresist mask 14 is wet-etched with an etching liquid such as KOH or APW, so that a projection 10A is formed on the principal surface of the substrate. In this etching process, by promoting a side etching, it is possible to form the projection 10A having a width shorter than the photoresist mask 14 in the current direction length of the weak link region 20A of the final or completed Josephson device.

As mentioned above, since the substrate 10 is formed of the silicon wafer, it is necessary to form a buffer layer on the substrate 10 before the oxide superconductor thin film is deposited on the substrate 10. For this purpose, after the photoresist mask 14 is removed, the principal surface having the projection 10A is continuously coated with MgAlO₄ by a CVD and with BaTiO₃ by a sputtering process, so that a buffer layer 16 is formed on the principal surface of the substrate 10.

Then, as shown in Figure 4F, an oxide superconductor thin film 20 is deposited on the buffer layer 16. The deposited oxide superconductor thin film 20 has to have a thickness larger than a height of the projection 10A. The oxide superconductor thin film 20 can be deposited, by for example an off-axis sputtering, a reactive evaporation, a CDV, etc. In this example, the off-axis sputtering is performed under the condition that a sputtering gas is composed of Ar and O₂ at the rate of Ar : O₂ = 9 : 1, the sputtering gas pressure is 10 Pa, and the temperature is 700°C.

The oxide superconductor thin film 20 as deposited has a uniform thickness anywhere, and therefore, has a projection corresponding to the projection 10A of the substrate 10. Therefore, it is necessary to planarize an upper surface of the deposited oxide superconductor thin film and to thin a oxide superconductor thin film portion on the projection 10A. For this purpose, as shown in Figure 4G, a photoresist layer 22 is deposited on the oxide superconductor thin film 20 in such a manner that the deposited photoresist layer 22 has a plat upper surface.

Thereafter, as shown in Figure 4H, a reactive ion etching or another etching process is performed so that the photoresist layer 22 and the oxide superconductor thin film 20 are etched back and the upper surface of the oxide superconductor thin film 20 is planarized.

With this planarization of the oxide superconductor thin film 20, the thickness of the oxide superconductor thin film 20 on the projection 10A becomes thinner than that of the oxide superconductor thin film 20 on the other portion of the oxide superconductor thin film 20. Therefore, the etch-back process is controlled so as to ensure that the thinner portion 20A of the oxide superconductor thin film 20 on the projection 10A has a thickness capable of forming a weak link of the Josephson device. Specifically, the thickness of the thinner portion 20A is controlled to be on the order of five nanometers to 10 nanometers.

The invention has thus been shown and described with reference to the specific embodiments. However, it should be noted that the present invention is in no way limited to the details of the illustrated structures but changes and modifications may be made within the scope of the appended claims.

## Claims

1. A superconducting Josephson device comprising a substrate (5) having an insulating projection (50) formed on a principal surface and an oxide superconductor thin film (1) covering the projection (50) formed on said principal surface and having substantially planar surface characterized in that the oxide superconductor thin film (1) has a thin portion on the projection, a first thick portion at one side of the projection and a second thick portion at the other side of the projection, the thin portion of the oxide superconductor thin film (1) positioned on the projection (50) of the substrate (5) having a thickness of five nanometers to ten nanometers in order to form a Josephson weak link, so that a superconducting current can flow between the first thick portion and the second thick portion through the thin portion of the oxide superconductor thin film.

2. A superconducting device as claimed in claim 1 wherein the oxide superconductor thin film (1) is formed of a material selected from the group consisting of a Y-Ba-Cu-O type compound oxide superconductor material, a Bi-Sr-Ca-Cu-O type compound oxide superconductor material, and a Tl-Ba-Ca-Cu-O type compound oxide superconductor material.

3. A superconducting device as claimed in claim 2 wherein the oxide superconductor thin film (1) is a c-axis oriented single crystal film.

4. A superconducting device comprising a substrate (5) having an insulating projection (50) formed on a principal surface and an oxide superconductor thin film (1) formed to cover the projection (50) formed on the principal surface and to have a substantially planar surface, the oxide superconductor thin film (1) having a thin portion on the projection, a first thick portion at one side of the projection, and a second thick portion at the other side of the projection, characterized in that a first electrode is formed on the first thick portion and a second electrode is formed on the second thick portion, so that a superconducting current can flow between the first and second electrodes through the thinned portion of the oxide superconductor thin film (1), a gate electrode (4) formed on the thin portion of the oxide superconductor thin film (1) positioned on the projection of the substrate (5), so that the superconducting device constitutes a super-FET, and the thin portion of the oxide superconductor thin film (1) positioned on the projection (50) of the substrate has a thickness of five nanometers to ten nanometers in order to form a superconducting channel (1A), so that the superconducting current flowing between the first and second electrodes through the thin portion of the oxide superconductor thin film is controllable by a voltage applied to the gate electrode (4).

5. A superconducting device as claimed in claim 4 wherein each of the first and second electrode and the gate electrode (4) is formed of : superconductor material or a normal conductor material.

6. A superconducting device as claimed in claim 1 wherein the substrate (5) is formed of a material selected from the group consisting of a MgO (100) substrate, a SrTiO₃ (100) substrate and a CdNdAlO₃ (001) substrate, and a semiconductor substrate.

7. A superconducting device as claimed in claim 1 wherein the substrate (5) is formed of a semiconducting material substrate and is coated with an insulating material layer which is formed of a MgAlO₄ layer and a BaTiO₃ layer.

8. A method of manufacturing a superconducting device, comprising the step of preparing a substrate (5) having a projection (50) formed on a principal surface thereof, and forming an oxide superconductor thin film (1) on said principal surface of the substrate including the projection (50) characterized in that the substrate (5) is prepared by selectively forming a resist (8) at a projection forming position on the principal surface of the substrate (5) and etching the principal surface of the substrate using the resist (8) as a mask so that on the principal surface of the substrate (5) there is formed a projection (50) having a width narrower than the resist mask by a side etching; the oxide superconductor thin film (1) has a thickness larger than the height of the projection, and a whole of an upper surface of the oxide superconductor thin film has a planar upper surface and therefore the thickness of the oxide superconductor thin film on the projection, being of five nanometers to ten nanometers, is thinner than the thickness of the oxide superconductor thin film on the substrate other than the projection.

9. A method as claimed in claim 8 wherein after formation of the oxide superconductor thin film (1), a resist layer (9) is coated on the oxide superconductor thin film (1) so as to have a flat upper surface, and the resist layer (9) and the oxide superconductor thin film (1) are etched back until the oxide superconductor thin film has the planar upper surface.

## Patentansprüche

1. Supraleitendes Josephson-Bauelement mit einem Substrat (5), welches einen isolierenden Vorsprung (50) auf einer Hauptoberfläche aufweist und mit einer oxidischen supraleitenden Dünnschicht (1), welche den Vorsprung (50) auf der Hauptoberfläche bedeckt und die eine im wesentlichen ebene Oberfläche aufweist, dadurch gekennzeichnet, daß die oxidische supraleitende Dünnschicht (1) einen dünnen Abschnitt auf dem Vorsprung, einen ersten dicken Abschnitt an einer Seite des Vorsprungs und einen zweiten dicken Abschnitt an der anderen Seite des Vorsprungs aufweist, wobei der dünne Abschnitt der oxidischen supraleitenden Dünnschicht (1) auf dem Vorsprung (50) des Substrates (5) eine Dicke von 5 bis 10 Nanometern aufweist, um so einen schwachen Josephson-Übergang zu bilden, so daß ein Supraleitungsstrom zwischen dem ersten dicken Abschnitt und dem zweiten dicken Abschnitt durch den dünnen Abschnitt der oxidischen supraleitenden Dünnschicht fließen kann.

2. Supraleitendes Bauteil nach Anspruch 1, bei dem die oxidische supraleitende Dünnschicht (1) aus einem Material besteht, das ausgewählt ist aus der Gruppe bestehend aus einem supraleitenden Y-Ba-Cu-O-Verbundoxid, einem supraleitenden Bi-Sr-Ca-Cu-O-Verbundoxid und einem supraleitenden Tl-Ba-Ca-Cu-O-Verbundoxid.

3. Supraleitendes Bauteil nach Anspruch 2, bei dem die oxidische supraleitende Dünnschicht (1) eine Einkristallschicht mit c-Achsorientierung ist.

4. Supraleitendes Bauteile mit einem Substrat (5) welches einen isolierenden Vorsprung (50) auf einer Hauptoberfläche aufweist und mit einer oxidischen supraleitenden Dünnschicht (1), welche den Vorsprung (50) auf der Hauptoberfläche bedeckt und eine im wesentlichen ebene Oberfläche aufweist, wobei die oxidische supraleitende Schicht (1) einen dünnen Abschnitt auf dem Vorsprung, einen ersten dicken Abschnitt an einer Seite des Vorsprungs und einen zweiten dicken Abschnitt an der anderen Seite des Vorsprungs aufweist, dadurch gekennzeichnet, daß eine erste Elektrode auf dem ersten dicken Abschnitt und eine zweite Elektrode auf dem zweiten dicken Abschnitt ausgebildet ist, so daß ein Supraleitungsstrom zwischen den ersten und zweiten Elektroden durch den Abschnitt verringerter Dicke der oxidischen supraleitenden Dünnschicht (1) fließen kann, daß eine Gate-Elektrode (4) auf dem Abschnitt verringerter Dicke der oxidischen supraleitenden Dünnschicht (1) auf dem Vorsprung des Substrates (5) ausgebildet ist, so daß das supraleitende Bauteil einen Super-FET darstellt und daß der dünne Abschnitt der oxidischen supraleitenden Dünnschicht (1) auf dem Vorsprung (50) des Substrats eine Dicke in der Größenordnung von 5 bis 10 Nanometern aufweist, um so einen supraleitenden Kanal (1A) auszubilden, so daß ein Supraleitungsstrom, der zwischen der ersten und zweiten Elektrode durch den dünnen Abschnitt der oxidischen supraleitenden Dünnschicht fließt durch eine an die Gate-Elektrode (4) angelegte Spannung gesteuert werden kann.

5. Supraleitendes Bauteil nach Anspruch 4, bei dem sowohl die erste als auch die zweite Elektrode und die Gate-Elektrode aus einem supraleitenden Material oder aus einem normal leitenden Material bestehen.

6. Supraleitendes Bauteil nach Anspruch 1, bei dem das Substrat (5) aus einem Material besteht, das ausgewählt ist aus der Gruppe bestehend aus einem MgO(100)-Substrat, einem SrTiO₃(110)-Substrat, einem CdNdAlO₃(001)-Substrat und einem Halbleiter-Substrat.

7. Supraleitendes Bauteil nach Anspruch 1, bei dem das Substrat (5) aus einem Halbleitersubstrat besteht und mit einer isolierenden Schicht bedeckt ist, die aus einer MgAlO₄-Schicht und aus einer BaTiO₃-Schicht besteht.

8. Verfahren zur Herstellung eines supraleitenden Bauteils, umfassend die Schritte des Herstellens eines Substrates (5), mit einem Vorsprung (50) auf einer seiner Hauptoberflächen, des Ausbildens einer oxidischen supraleitenden Dünnschicht (1) auf dieser Hauptoberfläche des Substrats einschließlich des Vorsprungs (50), dadurch gekennzeichnet, daß das Substrat (5) bearbeitet wird durch ausgewähltes Ausbilden einer Widerstandsschicht (8) auf einem Vorsprung, der auf der Hauptoberfläche des Substrats angeordnet ist, des Ätzens der Hauptoberfläche des Substrats, wobei die Widerstandsschicht (8) als Maske dient, so daß auf der Hauptoberfläche des Substrats (5) ein Vorsprung (50) entsteht mit einer Breite, die kleiner ist als diejenige der Widerstandsmaske durch ein Seitenätzverfahren; die oxidische supraleitende Dünnschicht (1) weist dabei eine Dicke auf, die größer ist als die Höhe des Vorsprungs, wobei die gesamte obere Oberfläche der oxidischen supraleitenden Dünnschicht eine ebene Oberfläche aufweist und damit eine Dicke der oxidischen supraleitenden Dünnschicht auf dem Vorsprung in der Größenordnung von 5 bis 10 Nanometern, wobei diese geringer ist als die Dicke einer oxidischen supraleitenden Dünnschicht auf den übrigen Teilen des Substrats.

9. Verfahren nach Anspruch 8, bei dem nach der Ausbildung der oxidischen supraleitenden Dünnschicht (1) eine Widerstandsschicht (9) auf der oxidischen supraleitenden Dünnschicht (1) derart abgeschieden wird, daß eine ebene Oberfläche entsteht, wobei die Widerstandsschicht (9) und die oxidische supraleitende Dünnschicht (1) so lange zurückgeätzt werden, bis die oxidische supraleitende Dünnschicht eine ebene Oberfläche aufweist.

## Revendications

1. Dispositif Josephson supraconducteur comprenant un substrat (5) comportant une partie isolante en saillie (50) formée sur une surface principale et un film mince d'oxyde supraconducteur (1) couvrant la partie en saillie (50) formée sur ladite surface principale et comportant une surface essentiellement plane, caractérisé en ce que le film mince d'oxyde supraconducteur (1) comporte une partie mince située sur la partie en saillie, une première partie épaisse d'un côté de la partie en saillie et une seconde partie épaisse au niveau de l'autre côté de la partie en saillie , la partie mince du film mince d'oxyde supraconducteur (1) située sur la partie en saillie (50) du substrat (5) présentant une épaisseur de cinq à dix nanomètres afin de former une liaison faible Josephson, de sorte qu'un courant supraconducteur peut circuler entre la première partie épaisse et la seconde partie épaisse à travers la partie mince du film mince d'oxyde supraconducteur.

2. Dispositif supraconducteur selon la revendication 1 dans lequel le film mince d'oxyde supraconducteur (1) est formé d'un matériau choisi dans le groupe constitué d'un matériau supraconducteur d'oxyde composé de type Y-Ba-Cu-O, d'un matériau supraconducteur d'oxyde composé de type Bi-Sr-Ca-Cu-O et d'un matériau supraconducteur d'oxyde composé de type Tl-Ba-Ca-Cu-O.

3. Dispositif supraconducteur selon la revendication 2 dans lequel le film mince d'oxyde supraconducteur (1) est un film monocristallin orienté selon l'axe c.

4. Dispositif supraconducteur comprenant un substrat (5) comportant une partie isolante en saillie (50) formée sur une surface principale et un film mince d'oxyde supraconducteur (1) formé pour recouvrir la partie en saillie (50) constituée sur la surface principale et pour présenter une surface essentiellement plane, le film mince d'oxyde supraconducteur (1) comportant une partie mince située sur la partie en saillie, une première partie épaisse au niveau d'un côté de la partie en saillie et une seconde partie épaisse au niveau de l'autre côté de la partie en saille, caractérisé en ce qu'une première électrode est formée sur la première partie épaisse et qu'une seconde électrode est formée sur la seconde partie épaisse , de sorte qu'un courant supraconducteur peut circuler entre les première et seconde électrodes à travers la partie amincie du film mince d'oxyde supraconducteur (1), une électrode de grille (4) formée sur la partie mince du film mince d'oxyde supraconducteur (1) située sur la partie en saillie du substrat (5) , de sorte que le dispositif supraconducteur constitue un FET-supra , et la partie mince du film mince d'oxyde supraconducteur (1) située sur la partie en saillie (50) du substrat présente une épaisseur de l'ordre de cinq nanomètres à dix nanomètres de manière à former un canal supraconducteur (1A), de sorte que le courant supraconducteur circulant entre les première et seconde électrodes à travers la partie mince du film mince d'oxyde supraconducteur peut être commandé par une tension appliquée à l'électrode de grille (4).

5. Dispositif supraconducteur selon la revendication 4 dans lequel chacune des première et seconde électrodes et l'électrode de grille (4) est constituée d'un matériau supraconducteur ou d'un matériau conducteur normal.

6. Dispositif supraconducteur selon la revendication 1 dans lequel le substrat (5) est formé d'un matériau choisi dans le groupe constitué d'un substrat de MgO(100), d'un substrat de SrTiO₃ (100) et d'un substrat de CdNdAlO₃ (001) et d'un substrat semi-conducteur.

7. Dispositif supraconducteur selon la revendication 1 dans lequel le substrat (5) est formé d'un substrat de matériau semi-conducteur et est recouvert d'une couche de matériau isolant qui est constituée d'une couche de MgAlO₄ et d'une couche de BatiO₃.

8. Procédé de fabrication d'un dispositif supraconducteur , comprenant l'étape consistant à préparer un substrat (5) comportant une partie en saillie (50) formée sur sa surface principale et à former un film mince d'oxyde supraconducteur (1) sur ladite surface principale du substrat comportant la partie en saillie (50) caractérisé en ce que le substrat (5) est préparé en formant sélectivement une résine photosensible (8) au niveau d'une position de formation de la partie en saillie sur la surface principale du substrat (5) et à graver la surface principale du substrat en utilisant la résine photosensible (8) comme masque, de façon que sur la surface principale du substrat (5) soit constituée une partie en saillie (50), présentant une largeur plus petite que le masque de résine photosensible, par une gravure latérale ; en ce que le film mince d'oxyde supraconducteur (1) présente une épaisseur supérieure à la hauteur de la partie en saillie et que la totalité de la surface supérieure du film mince d'oxyde supraconducteur présente une surface supérieure plane et, en conséquence, l'épaisseur du film mince d'oxyde supraconducteur sur la partie en saillie étant de cinq à dix nanomètres, est plus mince que l'épaisseur du film mince d'oxyde supraconducteur situé sur le substrat ailleurs que sur la partie en saillie.

9. Procédé selon la revendication 8 dans lequel, après formation du film mince d'oxyde supraconducteur (1), une couche de résine photosensible (9) est déposée sur le film mince d'oxyde supraconducteur (1) de façon à présenter une surface supérieure plane , et la couche de résine photosensible (9) et le film mince d'oxyde supraconducteur (1) sont gravés en retour jusqu'à ce que le film mince d'oxyde supraconducteur présente une surface supérieure plane .
